(19) Europäisches Patentamt
European Patent Office
Office européen des brevets

(11) **EP 1 945 003 B1**

(12) **EUROPEAN PATENT SPECIFICATION**

(45) Date of publication and mention
of the grant of the patent:
**16.03.2011 Bulletin 2011/11**

(51) Int Cl.:
*H05B 6/30* (2006.01)     *C30B 21/02* (2006.01)
*C01B 33/037* (2006.01)     *H01L 31/18* (2006.01)
*C30B 11/00* (2006.01)

(21) Application number: **07100485.7**

(22) Date of filing: **12.01.2007**

(54) **Directional solidification of a metal**

Gerichtete Erstarrung eines Metalls

Solidification directionnelle d'un métal

(84) Designated Contracting States:
**AT BE BG CH CY CZ DE DK EE ES FI FR GB GR HU IE IS IT LI LT LU LV MC NL PL PT RO SE SI SK TR**

(43) Date of publication of application:
**16.07.2008 Bulletin 2008/29**

(73) Proprietor: **INDUCTOTHERM CORP.
Rancocas,
New Jersey 08073 (US)**

(72) Inventors:
• **Fishman, Oleg S.
Maple Glen, PA 19002 (US)**
• **Belsh, Joseph T.
Mount Laurel, NJ 08054 (US)**
• **Raffner, Bernard M.
Moorestown, NJ 08057 (US)**
• **Prabhu, Satyen N.
Voorhees, NJ 08043 (US)**

(74) Representative: **Ackroyd, Robert
W.P. Thompson & Co.
55 Drury Lane
London
WC2B 5SQ (GB)**

(56) References cited:
**EP-A- 0 801 516     EP-A1- 1 431 405
WO-A1-00/28787**

## Description

### Field of the Invention

The present invention is related to directional solidification of a metal wherein magnetic induction heating is used to heat the metal prior to solidification.

### Background of the Invention

The metal silicon is used as a raw material in various applications based upon its purity. Regular grade silicon is nominally 99 % pure silicon and hyperpure silicon is nominally 99.99 % silicon. Hyperpure silicon is used extensively for the production of solid state devices and silicones. One method of producing crystalline silicon with purity up to hyperpure silicon is known as directional solidification. In this method a column of molten silicon with impurities is slowly cooled from the bottom upwards. With appropriate process parameters, crystalline silicon forms in the cooled region as most impurities remain in the molten portion of the mass. At the end of the process, the cooled mass is appropriately trimmed to remove outer regions of impurities and the crystalline silicon mass is further processed, for example, cut into thin wafers for use in the production of semiconductors. US Patents No. 6,136,091, No. 5,182,091, No. 4,243,471 and No. 4,218,418 disclose various methods of producing crystalline silicon by directional solidification.

WO-A-00/28787 discloses an induction heating device and process for controlling temperature distribution.

### Brief Summary of the Invention

In one aspect, the invention is a method of producing a high purity metal by providing a vessel with a plurality of induction coils surrounding the exterior of the vessel. Each of the plurality of induction coils is connected to one or more ac power supplies in a manner by which power may be selectively decreased and removed from each of the plurality of induction coils. Low purity metal in molten, semi-solid and solid state is placed in the vessel and heated by magnetic induction into a molten mass when ac current flows through each of the plurality of induction coils. Optionally the vessel may include means for removal of gross impurities from the molten mass prior to the directional solidification process, such as bubbling a suitable gas through the molten mass to bond impurities to the gas. Power to each of the plurality of induction coils is selectively decreased in a manner by which the molten mass begins to solidify at one end with progressive solidification to the other end. A cooling medium, such as cooling water in each of the plurality of induction coils, assists in the solidification of the molten mass. In other examples of the invention, the magnetic fields produced by the plurality of induction coils may be coupled with an electrically conductive susceptor placed in the vessel, or incorporated in the vessel, rather than with the molten mass in the vessel.

These and other aspects of the invention are set forth in the specification.

### Brief Description of the Drawings

The figures, in conjunction with the specification and claims, illustrate one or more non-limiting modes of practicing the invention. The invention is not limited to the illustrated layout and content of the drawings.

FIG. 1 is a cross sectional diagram of one example of a system for directional solidification of a metal of the present invention.

FIG. 2 is a simplified electrical diagram of one example of a power source and power distribution for use with the system for directional solidification of a metal of the present invention.

FIG. 3(a) through FIG. 3(f) is one example of a time-power management scheme for supplying electrical power to the induction coils used with a system for directional solidification of a metal of the present invention.

FIG. 4 illustrates push-out of a directionally solidified metal from a vessel used in a system for directional solidification of a metal of the present invention.

FIG. 5 illustrates one example of a system for directional solidification of a metal of the present invention wherein the vessel is magnetically coupled with the field produced by current flowing through induction coils surrounding the vessel.

### Detailed Description of the Invention

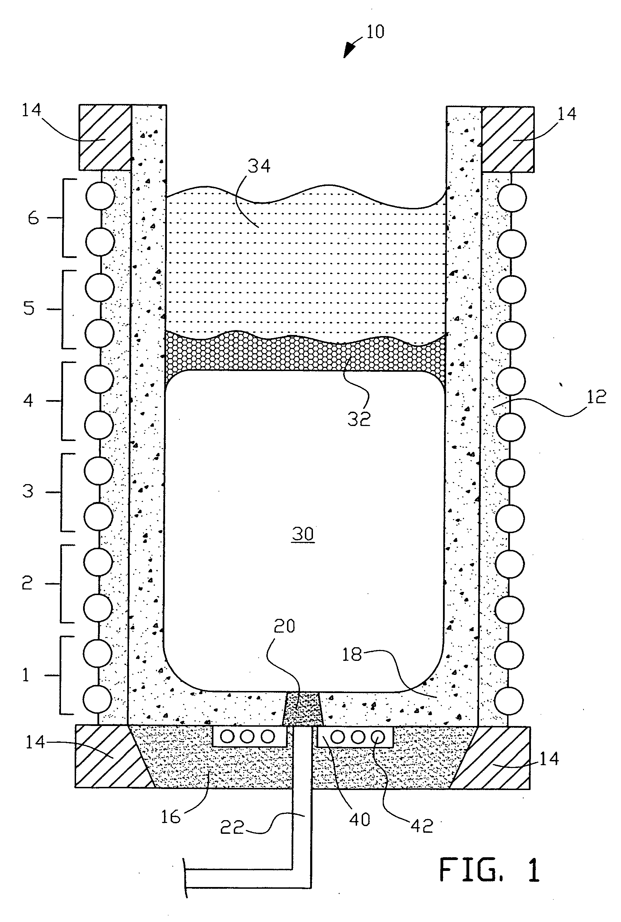

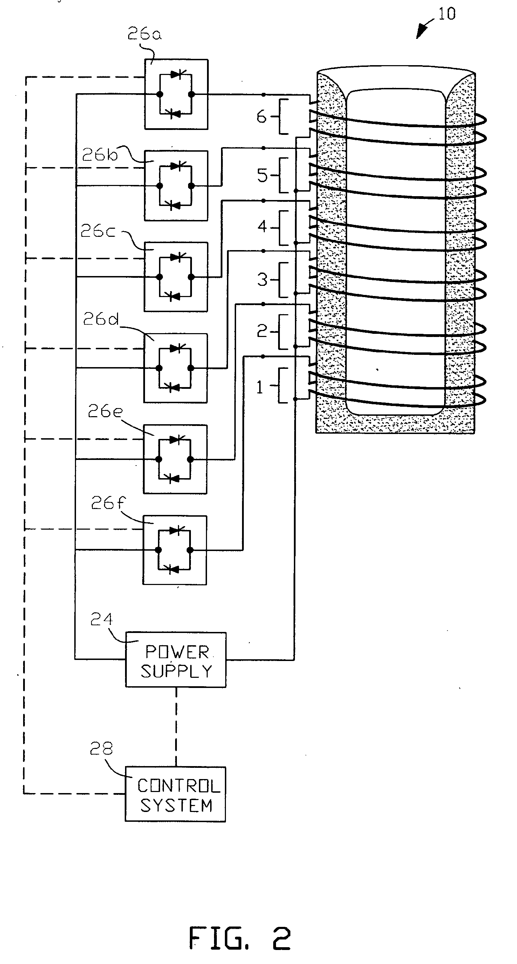

There is shown in FIG. 1 and FIG. 2 one example of a system for directional solidification of a metal, such as, but not limited to, silicon. Vessel 10 comprises a plurality of induction coils around a chamber, or vessel, for holding a molten mass of the metal. In this non-limiting example of the invention, each of six induction coils (coil 1 through coil 6) comprises a two-turn coil. In other examples of the invention, the number of individual coils and the number of coil turns in each coil can vary. The plurality of coils are held in place by suitable structural elements such as grout 12, blocks 14 and grout base 16 as shown in FIG. 1. Not shown in the figures are magnetic shunts that are typically placed around the outer circumference of the coils to support the coils and contain the magnetic fields produced when current flows through the coils. Also not shown is an outer container element for the vessel. Refractory 18, typically a particulate refractory material, is packed and sintered to form the inner walls of the chamber in which the molten metal will be placed. Typically the inner layer of refractory is sintered to a solid glass-like material while the outer regions of the refractory remain in particulate form.

The metal solidification process begins with a vessel holding molten metal. To reach that stage, molten metal may be poured into the vessel, or a small amount of molten metal heel may be placed in the vessel, and solid forms of metal (e.g. particulate, ingots and the like) may be added to the vessel for induction melting in the vessel. Prior to the beginning of the metal solidification process, one or more treatment processes may be performed on the molten metal in the vessel. For example optional porous plug **20** may be provided in the bottom of refractory **18** so that a pressurized gas, from a suitable source, may be injected into the molten metal via conduit **22.** The gas is selected for bonding with impurities in the molten metal so that as the gas bubbles through the molten metal it removes impurities to the surface of the molten metal in the vessel where they evaporate into the air, or are skimmed off the surface. This type of gas purging of a molten metal is one method of gross impurity removal prior to beginning the directional solidification process that produces a highly purified solid metal.

**FIG. 2** illustrates one example of a power source and power distribution system to the six induction coils surrounding vessel **10.** Power supply **24** is a suitable ac power source for providing power to each of the induction coils. In this non-limiting example of the invention, power is supplied to each induction coil by a suitable switching means, such as, but not limited to, back-to-back solid state switches **26a** through **26f** as shown in **FIG. 2.** Each coil has a common return power line to power supply **24.** Control system **28** controls the output power of the power supply, and opened (non-conducting) and closed (conducting) states of the solid state switches as further described below.

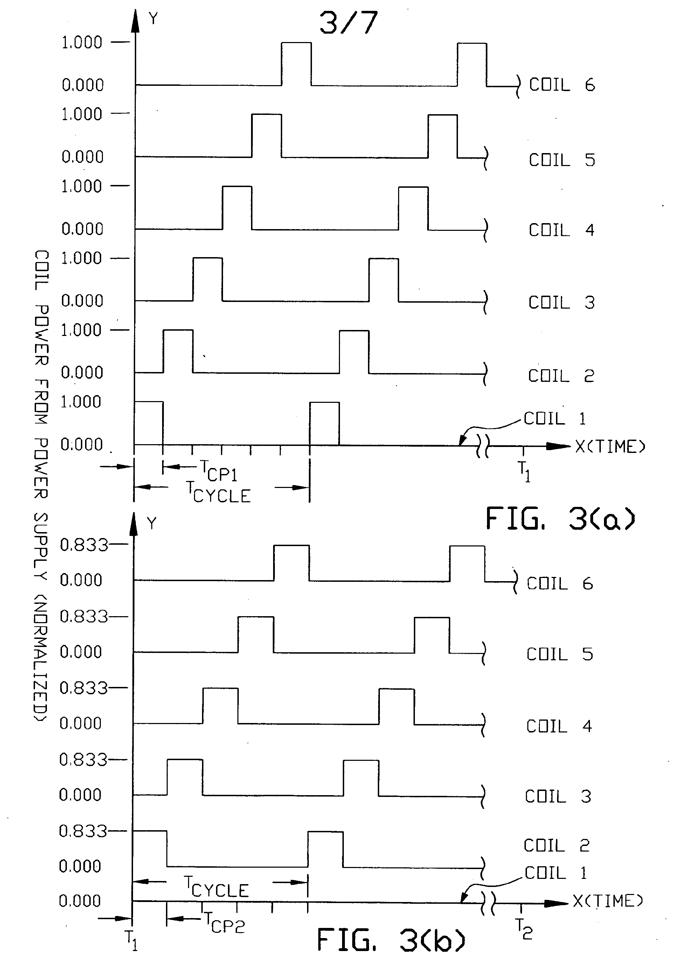

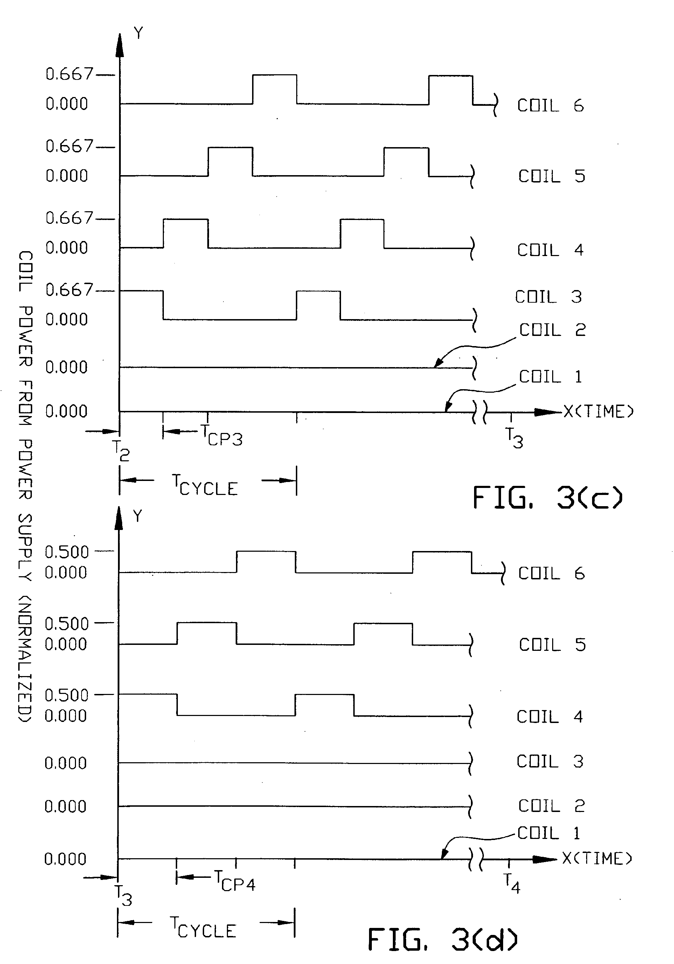

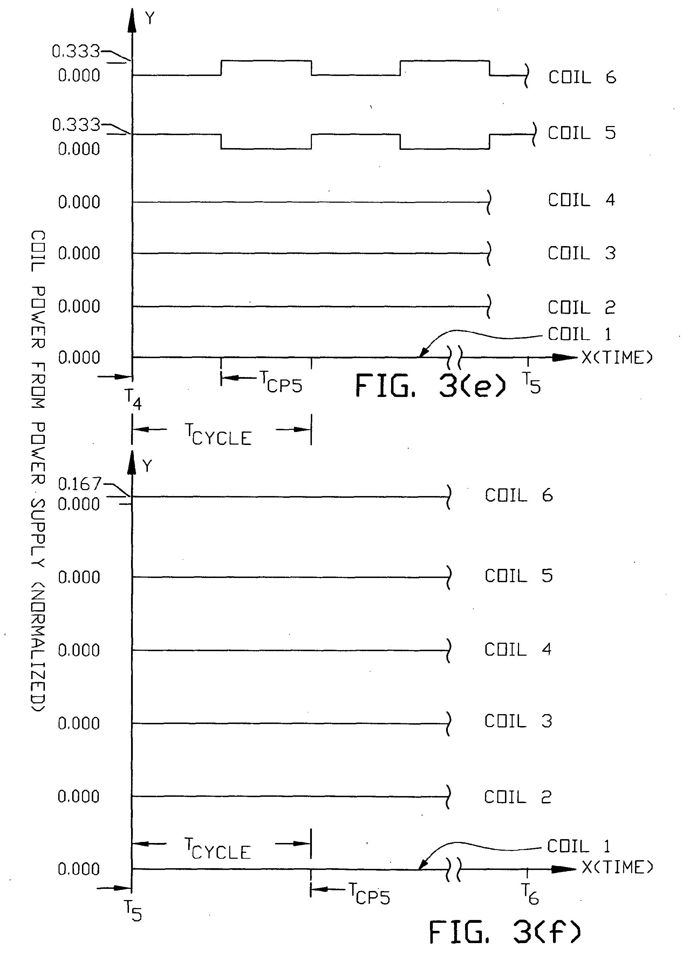

**FIG. 3(a)** through **FIG. 3(f)** illustrate one non-limiting example of a time-power management scheme executed by control system **28** to achieve directional solidification. In all of these figures, the x-axis represents time, and the y-axis represents normalized output power of power supply **24.** Power control may be accomplished by changing the supply's output voltage magnitude; output current magnitude; or a combination of output voltage and current magnitudes. One or more of the six induction coils receives output power from supply **24** for a time period within a power supply cycle period, which is identified as $T_{CYCLE}$ in the figures. In the first series of power supply cycle periods shown in **FIG. 3(a)** all six coils receive power in each cycle period for time period $T_{CP1}$. While $T_{CP1}$ is equal for all coils, in other examples of the invention, individual coil power periods may vary. The coil power switching scheme in **FIG. 3(a)** cyclically repeats as shown for $T_{CYCLE}$ until time $T_1$. At this time, the power switching scheme continues in **FIG. 3(b)** wherein induction coil 1 receives no power in a power supply cycle period. In this second series of power supply periods, coils 2 through 6 receive power in each cycle period for time period $T_{CP2}$. Since $T_{CP2}$ is greater than $T_{CP1}$, output power is proportionately reduced (normalized 0.833 output power since time period $T_{CP2}$ is 1.2 times longer than $T_{CP1}$) to maintain the same amount of electrical energy to each induction coil. The coil power switching scheme in **FIG. 3(b)** cyclically repeats as shown for $T_{CYCLE}$ until

time $T_2$. Similarly progressive power switching schemes are sequentially executed as illustrated in **FIG. 3(c)** through **FIG. 3(f)** wherein one additional coil receives no power in each progressive power supply cycle shown in each figure. In this fashion inductive heating of the molten metal in the vessel progressively decreases from the bottom to the top of the molten mass.

A cooling medium is selectively applied around the exterior of the vessel to assist in directional solidification of the molten metal. A suitable cooling medium can be provided in combination with the induction coils. For example the induction coils may be hollow induction coils with a cooling medium, such as water, flowing through the hollow coils. In this arrangement the cooling medium serves the dual purpose of keeping the coils cool when they are conducting current (primarily cooling of coils from $I^2R$ losses) and cooling the molten mass after power is selectively removed from the coils with a suitable time-power management scheme as executed by control system **28.**

**FIG. 1** also illustrates an optional bottom cooling plate **40** that may be provided at the bottom of the vessel. In this non-limiting example of the invention, the cooling plate is annular in shape and fitted around conduit **22.** One or more cooling passages **42** are provided in the cooling plate to provide a means for circulating a cooling medium in the plate to remove heat from the solidifying molten mass. In this arrangement bottom cooling cools the solidifying molten mass from the bottom while the side wall cooling medium, such as cooling water in hollow induction coils, cools the solidifying molten mass from the sides.

**FIG. 1** illustrates a directional solidification process wherein solidification is more than half completed. For example the time-power management scheme may be operating in the power switching scheme illustrated in **FIG. 3(e)** wherein induction coils **1** through **4** are not receiving power and the molten metal in the vessel has been directionally solidified into a highly purified crystalline metal solid **30.** Impurities **32** are disposed primarily above the metal solid and remaining molten metal **34** remains to be purified. After the required induction heating of the molten mass with all coils being powered as shown in **FIG. 3(a),** the time period for each coil power switching scheme illustrated in **FIG. 3(b)** through **FIG. 3 (e)** may be as long as one or more days.

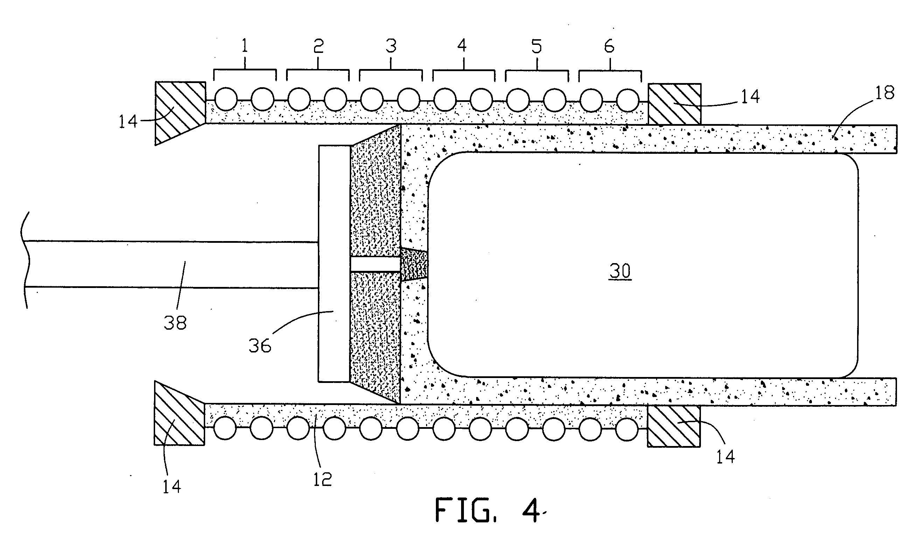

Once the entire molten mass is solidified, vessel **10** can be tilted with a suitable tilt mechanism, and a pushing means, such as pusher plate **36** connected to power driven cylinder **38** can be used to push solidified metal **30,** along with surrounding refractory **18,** out of the vessel as illustrated in **FIG. 4.** Further processing can include removal of the refractory from the solid metal and trimming the outer boundaries of the solidified metal that may contain impurities. The highly purified metal is then further processed, for example, if silicon, by sawing into thin wafers for use in making semiconductor components. Vessel **10** can be reused by repacking it with new refractory and sintering the refractory.

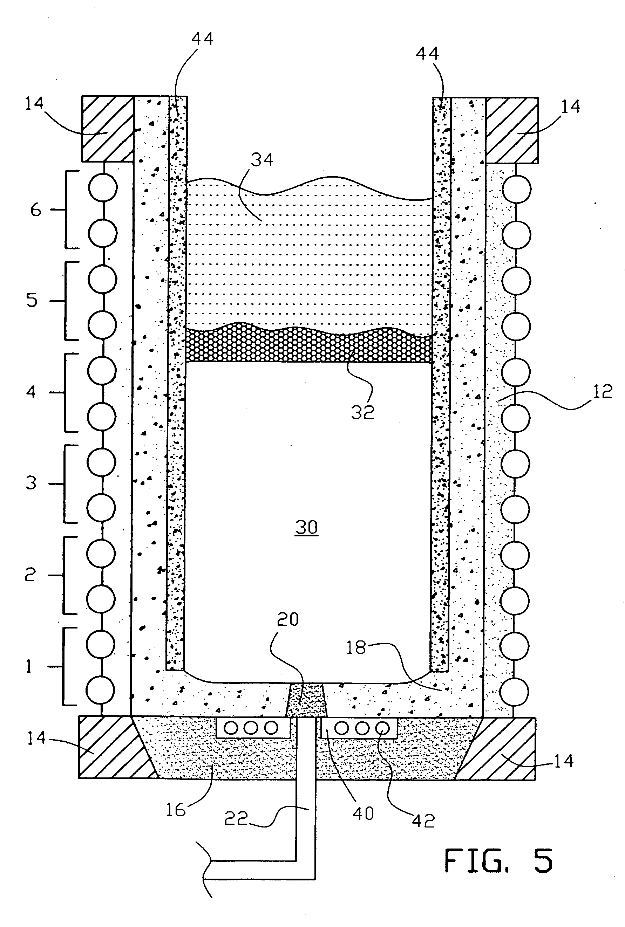

Vessel **10** used in the above examples of the invention is a substantially non-electrically conductive vessel and the magnetic fields produced by the flow of currents in the induction coils are coupled with the molten mass in the vessel to inductively heat the melt. When the molten mass is a good electrical conductor, such as molten silicon, (75 $\Omega^{-1}$ cm$^{-1}$; as opposed to crystalline silicon's low conductivity value of 0.3 $\Omega^{-1}$ cm$^{-1}$) induction coupling directly with the molten metal to heat the melt works well. When the molten material is not a good electrical conductor, an electrically conductive susceptor, rather than the molten mass in the vessel, can be used for magnetic coupling with the produced magnetic fields as illustrated in **FIG. 5.**

Susceptor **44** may be an aggregate electrically conductive material, such as an open ended cylinder sleeve formed from silicon carbide that is inserted into the vessel, or a composite electrically conductive material such as silicon carbide particles dispersed in non-electrically conductive refractory material. In other examples of the invention the susceptor may be otherwise integrated into the vessel to form a susceptor vessel. The thickness of the electrically conductive material should be at least one standard (induced eddy current) depth of penetration for maximum magnetic coupling with the applied magnetic fields. The depth of induced eddy current penetration into any material is dependent upon the frequency of the induced eddy current (applied field), and the electrical conductivity and magnetic permeability of the material. More specifically the depth of induced eddy current penetration ($\delta$) is given by the equation:

$$\delta = 503 \, (\rho / \mu F)^{1/2}$$

where $\rho$ is the electrical resistivity of the material in $\Omega$m; $\mu$ is the relative permeability of the material; and F is the frequency of the induced eddy current resulting from the applied field when one or more of induction coils **1** through **6** are powered from a power supply **24** with an output frequency F. One standard depth of penetration is the depth at which the eddy current density has decreased to 1/e (where e is Euler's constant, 2.218...).

In other examples of the invention a suitable sensor can be used to monitor the progress of the directional solidification. For example the sensor may direct electromagnetic waves of an appropriate wavelength into the melt so that the waves reflect back to the sensor at the molten metal/impurities interface, and/or the solid metal/impurities interface to monitor progress of the solidification. An output of the sensor that is proportional to the real time height of one or both of the above interfaces may be used to dynamically control the time-power management scheme for coil power switching.

Other coil arrangements are contemplated in the scope of the invention. For example, overlapping coils may be used to refine removal of heat from the molten mass in the vessel. Further the number of coils used in the above examples does not limit the scope of the invention. In some examples of the invention, air cooled induction coils may be used and separate cooling coils may be provided around the exterior of the vessel, or integrated into the vessel.

Other types of power supply and distribution arrangements are contemplated within the scope of the invention. For example each coil may be powered by an individual power supply, or separate power supplies may power individual groups of coils.

The examples of the invention include reference to specific electrical components. One skilled in the art may practice the invention by substituting components that are not necessarily of the same type but will create the desired conditions or accomplish the desired results of the invention. For example, single components may be substituted for multiple components or vice versa.

The foregoing examples do not limit the scope of the disclosed invention. The scope of the disclosed invention is further set forth in the appended claims.

**Claims**

1. A method of directional solidification of a molten mass of metal, the method comprising:

   providing a vessel (10) for containing a molten mass (34) of a metal which is to be directionally solidified, the vessel being surrounded by a plurality of induction coils (1, 2, 3, 4, 5. 6) extending around the exterior of the vessel and surrounding respective portions of the height of the vessel, the coils being connected to a single source of ac power for energisation of the cois;
   placing in the vessel a mass of metal to be directionally solidified, the mass being at least in part molten; and
   controlling the supply of ac power from the source thereof to the induction coils over a first period of time ($T_1$) in such a manner that the coils are energised and heat is supplied to the mass (34) of metal placed in the vessel; and subsequently controlling the supply of ac power from the source thereof to the induction coils over a second period of time ($T_2 + T_3 + T_4 + T_5 + T_6$) in such a manner that the induction coils are de-erergised over the second time period progressively in an upward direction from the bottom to the top of the vessel so that solidification of the mass of metal takes place over the second time period progressively in a direction from the bottom to the top of the mass of metal.

2. A method according to claim 1, including the step of progressively cooling the molten mass of the metal in the vessel from the bottom to the top of the molten mass of the metal in the vessel.

3. A method according to claim 1 or 2, including the step of pushing the solidified metal out of the vessel.

4. A method according :o any one of claims 1 to 3, including the step of placing or incorporating an electrically conductive susceptor in the vessel, so that the molten mass (34) of metal is heated during the first time period by eddy currents induced in the susceptor.

5. A method according to any one of claims 1 to 4, in which the molten mass (34) of metal is heated during the first time period by eddy currents induced in the metal.

**Patentansprüche**

1. Verfahren einer gerichteten Erstarrung einer Metallschmelze, wobei das Verfahren Folgendes aufweist:

Vorsehen eines Behälters (10) zum Aufnehmen einer Schmelze (34) eines Metalls, welches gerichtet erstarren soll, wobei der Behälter von einer Mehrzahl von Induktionsspulen (1, 2, 3, 4, 5, 6) umgeben ist, die sich um die Außenseite des Behälters herum erstrecken und jeweilige Höhenbereiche des Behälters umgeben, wobei die Spulen mit einer einzelnen Wechselstromquelle zur Erregung der Spulen verbunden sind; Anordnen einer Metallmasse im Behälter, die gerichtet erstarren soll, wobei die Masse zumindest teilweise geschmolzen wird; und Steuern/Regeln der Wechselstromversorgung von deren Quelle zu den Induktionsspulen über eine erste Zeitdauer ($T_1$) in der Weise, dass die Spulen unter Strom gesetzt werden und die Wärme der im Behälter angeordneten Masse (34) des Metalls zugeführt wird; und Nachfolgendes Steuern/Regeln der Wechselstromversorgung von deren Quelle zu den Induktionsspulen über eine zweite Zeitdauer ($T_2+T_3+T_4+T_5+T_6$) in der Weise, dass die Induktionsspulen über die zweite Zeitdauer fortschreitend in eine Aufwärtsrichtung vom Boden zum oberen Ende des Behälters nicht mit Strom versorgt werden, so dass die Erstarrung der Metallmasse über die zweite Zeitdauer fortschreitend in eine Richtung vom Boden zum oberen Bereich der Metallmasse stattfindet.

2. Verfahren gemäß Anspruch 1, wobei es den Schritt des fortschreitenden Abkühlens der Schmelze des Metalls im Behälter vom Boden zum oberen Bereich der Schmelze des Metalls im Behälter umfasst.

3. Verfahren gemäß Anspruch 1 oder 2, wobei es den Schritt des Ausstoßens des erstarrten Metalls aus dem Behälter umfasst.

4. Verfahren gemäß einem der Ansprüche 1 bis 3, wobei es den Schritt des Anordnens oder Aufnehmens eines elektrisch leitfähigen Suszeptors im Behälter umfasst, so dass die Schmelze (34) des Metalls während der ersten Zeitdauer durch die im Suszeptor induzierten Wirbelströme erwärmt wird.

5. Verfahren gemäß einem der Ansprüche 1 bis 4, bei dem die Schmelze (34) des Metalls während der ersten Zeitdauer durch die im Metall induzierten Wirbelströme erwärmt wird.

**Revendications**

1. Procédé de solidification directionnelle d'une masse de métal en fusion, le procédé comportant :

la mise en oeuvre d'un récipient (10) destiné à contenir une masse (34) d'un métal en fusion à des fins de solidification directionnelle, le récipient étant entouré d'une pluralité de bobines d'induction (1, 2, 3, 4, 5, 6) s'étendant autour de l'extérieur du récipient et entourant des parties respectives de la hauteur du récipient, les bobines étant couplées à une seule source d'alimentation en c.a. à des fins de mise sous tension des bobines ; la mise en place dans le récipient d'une masse de métal à des fins de solidification directionnelle, la masse étant au moins en partie en fusion ; et la régulation de l'alimentation en c.a. depuis la source de celle-ci jusqu'aux bobines d'induction au cours d'une première période de temps ($T_1$) de telle manière que les bobines sont mises sous tension et de la chaleur est apportée à la masse (34) de métal se trouvant dans le récipient ; et par la suite la régulation de l'alimentation en c.a. depuis la source de celle-ci jusqu'aux bobines d'induction au cours d'une seconde période de temps ($T_2 + T_3 + T_4 + T_5 + T_6$) de telle manière que les bobines d'induction sont mises hors tension au cours de la seconde période de temps de manière progressive dans une direction allant vers le haut depuis la partie inférieure jusqu'à la partie supérieure du récipient de sorte que la solidification de la masse de métal s'effectue au cours de la seconde période de temps de manière progressive dans une direction allant depuis la partie inférieure jusqu'à la partie supérieure de la masse de métal.

2.  Procédé selon la revendication 1, comprenant l'étape consistant à refroidir progressivement la masse de métal en fusion dans le récipient depuis la partie inférieure jusqu'à la partie supérieure de la masse de métal en fusion dans le récipient.

3.  Procédé selon la revendication 1 ou la revendication 2, comprenant l'étape consistant à pousser le métal solidifié hors du récipient.

4.  Procédé selon l'une quelconque des revendications 1 à 3, comprenant l'étape consistant à placer ou à incorporer un suscepteur conducteur dans le récipient, de sorte que la masse (34) de métal en fusion est chauffée au cours de la première période de temps par des courants de Foucault induits dans le suscepteur.

5.  Procédé selon l'une quelconque des revendications 1 à 4, dans lequel la masse (34) de métal en fusion est chauffée au cours de la première période de temps par des courants de Foucault induits dans le métal.

FIG. 1

FIG. 2

3/7

FIG. 3(a)

FIG. 3(b)

FIG. 3(c)

FIG. 3(d)

FIG. 3(e)

FIG. 3(f)

FIG. 4.

FIG. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6136091 A
- US 5182091 A
- US 4243471 A
- US 4218418 A
- WO 0028787 A